# EUROPÄISCHE PATENTSCHRIFT

(11) **EP 2 862 426 B1**
(45) Veröffentlichungstag und Bekanntmachung des Hinweises auf die Patenterteilung: **05.05.2021**
(21) Anmeldenummer: 13732403.4
(22) Anmeldetag: 18.06.2013
(51) Int. Cl.: H05K 3/34

(54) **VERFAHREN ZUR FERTIGUNG VON DRUCKSENSOREN**
METHOD FOR FABRICATION OF PRESSURE SENSORS
PROCÉDÉ POUR FABRIQUER DES CAPTEURS DE PRESSION

(30) Priorität: 19.06.2012 DE 102012105297
(43) Veröffentlichungstag der Anmeldung: 22.04.2015
(73) Patentinhaber: Endress+Hauser SE+Co. KG, 79689 Maulburg (DE)
(72) Erfinder: ROSSBERG, Andreas, 79713 Bad Säckingen (DE); SCHMIDT, Elke, 79713 Bad Säckingen (DE); BIRGEL, Dietmar, 79650 Schopfheim (DE)
(74) Vertreter: Andres, Angelika Maria
(86) Internationale Anmeldenummer: PCT/EP2013/062580
(87) Internationale Veröffentlichungsnummer: WO 2013/189911

(56) Entgegenhaltungen:
- DE-A1- 10 111 718
- DE-A1-102008 054 879
- JP-A- 2000 151 085
- US-A- 5 914 536
- US-B1- 6 179 198

## Beschreibung

Die vorliegende Erfindung betrifft ein Verfahren zum Fertigen von Drucksensoren.

Moderne Messgeräte weisen eine Vielzahl an elektronischen Bauteilen auf. Die elektronischen Bauteile sind in der Regel über Lötungen mit einem Träger verbunden. Die Verbindung größerer Komponenten mit einem Träger wird oftmals mittels mehrerer Verbindungselemente, beispielsweise in Form von bolzenförmigen Bauteilen, hergestellt.

Die Japanische Patentanmeldung JP2000151085 beschäftigt sich mit einem Leiterplatte-Montageverfahren für elektronische Bauteile, bei dem elektronische Teile auf einer Leiterplatte mit einer hohen Dichte zu montieren sind. Verbindungselektroden des elektronischen Bauteils werden mit den Kontaktflächen über Lotbumps verbunden, die einen nicht schmelzenden Kern enthalten.

Das US Patent 5,914,536 offenbart ein rechteckiges Flip-Chip-Bauteil, welches auf einer Leiterplatte mit einer Vielzahl von Anschlusselektroden zu montieren ist. Hierzu werden Lötperlen eingesetzt, welche jeweils einen Abstandhalter umgeben, der zwischen einer Kontaktfläche des rechteckigen Flip-Chip Bauteils und einer Anschlusselektrode angeordnet ist.

Die Offenbarungsschrift DE 10 2008 054 879 A1 beschreibt ein Verfahren zur Herstellung eines Drucksensors.

Das US Patent US 6179198 B1 offenbart ein Verfahren zum Löten von Flip-Chips auf Leiterplatten.

Die Offenbarungsschrift DE 101 11 718 A1 beschreibt ein elektronisches Schaltungsbauteil mit mehreren Leiterplatten, auf denen elektronische Teile montiert sind und die dreidimensional zusammengebaut sind.

Zur Herstellung der Lötverbindung wird in der Regel Lot auf den Träger aufgebracht, das zu verbindende Bauteil aufgesetzt und der so bestückte Träger einem Lötofen zugeführt. Dort wird das Lot aufgeschmolzen und so eine Verbindung zwischen Bauteil und Träger hergestellt. Durch das Eigengewicht des Bauteils und/oder die Kraft beim Aufsetzen des Bauteils kann das Bauteil bis auf einen Nullspalt einsinken. Oftmals verbleibt nur eine sehr dünne, wenige Mikrometer dicke Lötschicht unter dem Bauteil. Eine derartige Verbindung ist anfällig gegenüber der Bildung von Rissen, insbesondere verursacht durch wechselnde Temperaturen. Risse schwächen die mechanische Stabilität der Verbindung und können zu einem Loslösen des Bauteils von dem Träger führen. Darüber hinaus kann ein über die Verbindung hergestellter elektrischer Kontakt unterbrochen werden.

Die Aufgabe der Erfindung besteht darin, ein Verfahren zur Fertigung von Drucksensoren anzugeben, wobei eine auf einer Leiterplatte montierte Sensorelektronik über Lötungen mit einem keramischen drucksensitiven Sensorelement verbunden wird, wobei das Verfahren die Herstellung einer zuverlässigen und stabilen Verbindung zwischen einem Bauteil und einem Träger über eine Lötung ermöglicht.

Die Aufgabe wird erfindungsgemäß gelöst durch ein Verfahren zur Fertigung von Drucksensoren, wobei:
eine auf einer Leiterplatte montierte Sensorelektronik mittels mehrerer metallischer oder metallisierter bolzenförmiger Verbindungselemente über Lötungen mit einem keramischen drucksensitiven Sensorelement verbunden wird, zum Verbinden der bolzenförmigen Verbindungselemente mit dem keramischen Sensorelement eine Lötung zwischen jeweils einer ersten Kontaktfläche eines Verbindungselements und einer zweiten Kontaktfläche des Sensorelements erfolgt, über die metallischen oder metallisierten bolzenförmigen Verbindungselemente und die Lötungen gleichzeitig auch die elektrische Kontaktierung des Sensorelements erfolgt, jeweils mindestens ein Abstandshalter an der ersten Kontaktfläche der Verbindungselemente einstückig angeformt ist, um eine Beabstandung der ersten Kontaktfläche des Verbindungselements und der zweiten Kontaktfläche des Sensorelements zu bewirken, die Abstandshalter bolzenförmig ausgestaltet sind, die Abstandshalter eine Höhe zwischen 100 Mikrometer und 300 Mikrometer aufweisen, und der Durchmesser der Abstandshalter zwischen 10 und 40 Prozent des Durchmessers der ersten Kontaktfläche des Verbindungselements beträgt.

Erfindungsgemäß wird also mindestens ein Abstandshalter derart ausgestaltet und zwischen der ersten Kontaktfläche und der zweiten Kontaktfläche angeordnet, dass die erste Kontaktfläche und die zweite Kontaktfläche voneinander beabstandet sind und dass die Lötung derart ausgeführt wird, dass das Verbindungselement und das Sensorelement über die erste Kontaktfläche und die zweite Kontaktfläche miteinander verbunden werden.

Die bei dem erfindungsgemäßen Verfahren verwendeten Verbindungselemente zur Herstellung einer Verbindung zwischen der Leiterplatte und dem Sensorelement werden im Weiteren auch "Bauteile" genannt. Das Sensorelement wird im Weiteren auch "Träger" genannt.

Die beiden Kontaktflächen werden über Lot miteinander verbunden, falls der Durchmesser des Abstandshalters geringer ist als der Durchmesser der Kontaktflächen.

Bei dem Lot handelt es sich beispielsweise um ein Weichlot. Insbesondere für einen Träger aus einem keramischen Material wird vorzugsweise Aktivlot verwendet.

Erfindungsgemäß wird der Abstandshalter aus einem Material gefertigt, dessen Schmelzpunkt oberhalb der bei der Lötung vorherrschenden Temperatur liegt. Der Abstandshalter behält seine Kontur bei der Lötung zumindest im Wesentlichen bei.

Erfindungsgemäß wird der Abstandshalter einstückig an dem Bauteil angeformt. Der Abstandshalter kann insbesondere einstückig mit dem die Kontaktfläche aufweisenden Abschnitt des Bauteils ausgebildet sein.

Erfindungsgemäß wird der Abstandshalter bolzenförmig ausgestaltet.

Eine weitere Ausgestaltung sieht vor, dass ein Formteil auf den bolzenförmigen Abstandshalter aufgesetzt wird, wobei die Höhe des Formteils zumindest gleich der Höhe des Abstandshalters ist, und wobei das Material des Formteils derart gewählt wird, dass das Formteil bei der Lötung zumindest im Wesentlichen konturstabil bleibt. In einer hiermit verbundenen Weiterbildung wird ein Lot auf das Formteil aufgebracht, welches bei der Lötung aufgeschmolzen wird. Es werden also zwei Materialien mit unterschiedlichen Schmelzpunkten kombiniert, wobei zumindest der tiefer liegende Schmelzpunkt bei der Lötung erreicht wird.

Eine Ausgestaltung beinhaltet, dass das Formteil aus einem duktilen Material gefertigt werden.

Erfindungsgemäß wird das Bauteil mit einem keramischen Träger verbunden. Beispielsweise handelt es sich bei dem Trägermaterial um eine AluminiumoxidKeramik.

In einer Ausgestaltung wird die Lötung mit einem Aktivlot ausgeführt. Unter einem Aktivlot ist ein Lot zu verstehen, das eine reaktive Komponente enthält. Das Aktivlot ist beispielsweise eine Silber-Kupfer-Verbindung oder eine Silber-Kupfer-NickelVerbindung, welche jeweils Titanhydrid als reaktive Komponente enthält.

Erfindungsgemäß ist an der ersten Kontaktfläche des Bauteils mindestens ein Abstandshalter angeformt, welcher dazu ausgestaltet ist, eine Beabstandung der ersten Kontaktfläche des Bauteils und der zweiten Kontaktfläche des Trägers zu bewirken.

In einer Ausgestaltung sind das Bauteil und der Abstandshalter aus einem Metall oder einer Metalllegierung gefertigt.

Erfindungsgemäß weist der Abstandshalter eine Höhe zwischen 100 Mikrometer und 300 Mikrometer auf. Unter der Höhe des Abstandshalters ist die Abmessung entlang einer Achse zu verstehen, welche senkrecht zu der ersten Kontaktfläche verläuft. Die Höhe gibt an, wie weit der Abstandshalter von der ersten Kontaktfläche vorsteht und definiert den Mindestabstand, welchen die erste Kontaktfläche bei einer Verbindung mit dem Träger zu der zweiten Kontaktfläche des Trägers aufweist.

Erfindungsgemäß ist der Durchmesser des Abstandshalters geringer als der Durchmesser der ersten Kontaktfläche des Bauteils.

Erfindungsgemäß beträgt der Durchmesser des Abstandshalters zwischen 10 und 40 Prozent, bevorzugt zwischen 15 und 20 Prozent, des Durchmessers der ersten Kontaktfläche des Bauteils. Vorzugsweise ist der Abstandshalter im Zentrum der ersten Kontaktfläche angeordnet.

Die Erfindung findet bei der Fertigung von Drucksensoren Anwendung: hierbei wird eine auf einer Leiterplatte montierte Sensorelektronik mittels mehrerer bolzenförmiger Bauteile über Lötungen mit einem keramischen drucksensitiven Sensorelement verbunden. Über die metallischen oder metallisierten bolzenförmigen Bauteile und die Lötungen erfolgt gleichzeitig auch die elektrische Kontaktierung des Sensorelements. Der Abstandshalter stellt sicher, dass ein elastisches Element zwischen den bolzenförmigen Bauteilen und dem Sensorelement verbleibt, sodass eine belastbare Verbindung zwischen Sensorelement und Sensorelektronik besteht.

Die Erfindung wird anhand der nachfolgenden Figuren näher erläutert.
Fig. 1 zeigt eine schematische Detailansicht der Lötung zwischen einem Bauteil und einem Träger;
Fig. 2a zeigt schematisch einen vorteilhaften Aufbau eines Bauteils vor der Lötung;
Fig. 2b zeigt schematisch das Bauteil aus Fig. 2a nach der Lötung.

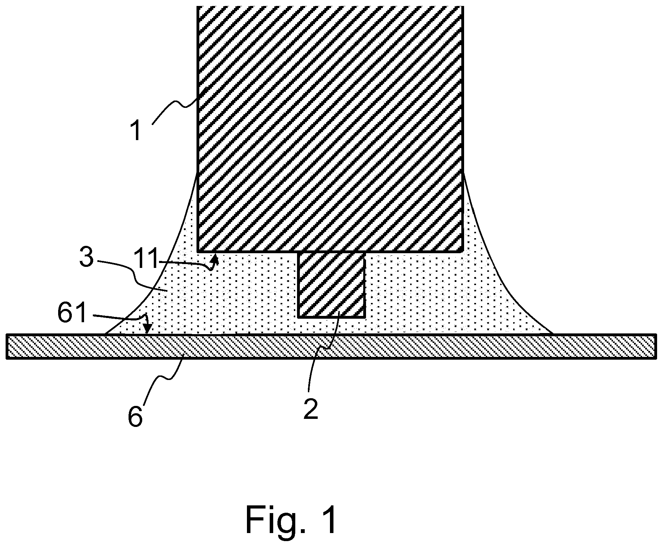

In Fig. 1 ist ein erfindungsgemäßes Bauteil 1 dargestellt, welches über eine Lötung mit einem Träger 6 verbunden ist. Das Bauteil 1 weist eine erste Kontaktfläche 11 zur Verbindung mit dem Träger 6 auf. Vorzugsweise ist zumindest die Kontaktfläche 11 metallisch. Bei dem Träger 6 handelt es sich um eine Platte oder um einen Körper mit zumindest einem flächigen Abschnitt, welcher als zweite Kontaktfläche 61 dient. Der Träger 6 ist aus einer Keramik gefertigt. Vorzugsweise ist der Träger 6 im Bereich der zweiten Kontaktfläche 61 metallisiert. Das Bauteil 1 ist aus einem Metall oder einer Metalllegierung gefertigt, beispielsweise aus Tantal.

An der Kontaktfläche 11 des Bauteils 1 ist ein Abstandshalter 2 angeformt. Der Abstandshalter 2 ist zumindest anteilig aus einem duktilen Material gefertigt. Der Abstandshalter 2 besteht aus einem Metall oder einer Metalllegierung. Der Abstandshalter 2 ist einstückig mit dem Bauteil 1 ausgeführt.

Im dargestellten Ausführungsbeispiel ist der Abstandshalter 2 bolzenförmig ausgestaltet. Die Höhe des Abstandshalters 2 definiert den Mindestabstand, welchen die erste Kontaktfläche 11 zum Träger 6 beibehält und beträgt vorzugsweise zwischen 0,1 mm und 0,3 mm.

Zum Verbinden des Bauteils 1 mit dem Träger 6 wird Lot 3, beispielsweise in Form einer Lötpaste, auf die zweite Kontaktfläche 61 aufgebracht und das Bauteil 1 derart auf den Träger 6 aufgesetzt, dass die erste Kontaktfläche 11 des Bauteils 1 oberhalb der zweiten Kontaktfläche 61 des Trägers 6 positioniert ist. Bei einem keramischen Träger 6 kann die Lötung auch mittels Aktivlot erfolgen. Der keramische Träger 6 ist beispielsweise aus Aluminiumoxid gefertigt. Als Aktivlot eignet sich beispielsweise eine Verbindung aus Silber und Kupfer, oder Silber, Kupfer und Nickel, unter Beigabe von Titanhydrid, insbesondere Ag72Cu28 + 12% Ti-Hydrid oder Ag56Cu42Ni3 + 8% Ti-Hydrid. Durch den Abstandshalter 2 wird hierbei ein Abstand zwischen den beiden Kontaktflächen 11, 61 eingehalten, welcher mindestens der Höhe des Abstandshalters 2 entspricht. Dann wird der Aufbau erhitzt, beispielsweise indem der bestückte Träger 6 einem Lötofen zugeführt wird. Das Lot 3 wird hierbei aufgeschmolzen und füllt den auf Grund des bolzenförmig ausgestalteten Abstandshalters 2 vorhandenen Zwischenraum zwischen der ersten Kontaktfläche 11 und der zweiten Kontaktfläche 61 aus, sodass die erste Kontaktfläche 11 mit der zweiten Kontaktfläche 61 verbunden wird. Der Abstandshalter 2 stellt den Verbleib eines elastischen Elements unter dem Bauteil 1 sicher.

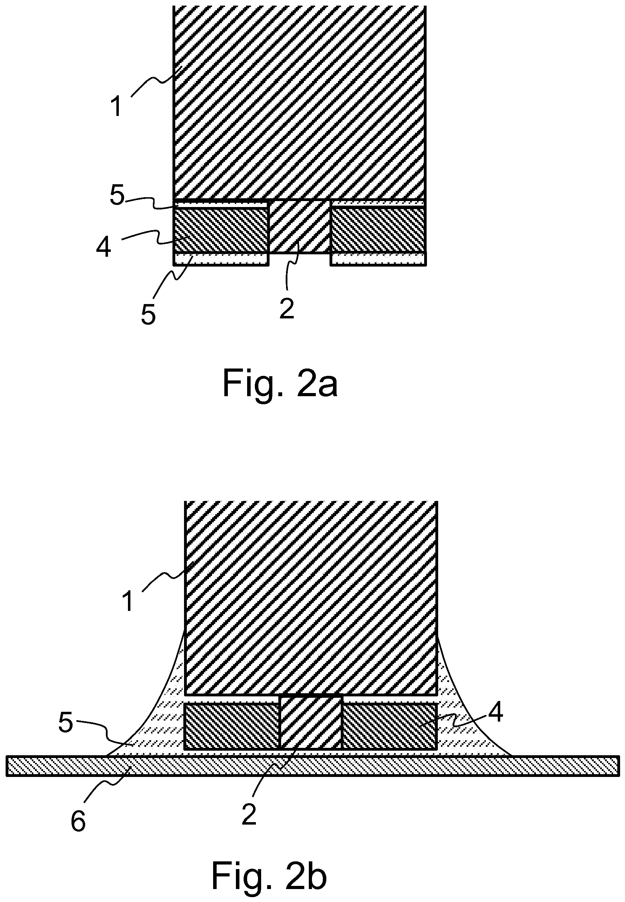

Fig. 2a zeigt ein erfindungsgemäßes Bauteil 1, welches für eine weitere Verbesserung der Stabilität der Verbindung mit einem Formteil 4 ausgestattet ist. Das Formteil 4 besteht aus einem duktilen Material, beispielsweise aus einem Weichlot, und ist mit einer ebenfalls duktilen Beschichtung 5, beispielsweise in Form einer Lötpaste, versehen. Die Duktilität des Formteils 4 ist hierbei mindestens genauso hoch wie die der Beschichtung 5. Die Beschichtung 5 ist zumindest auf die den Kontaktflächen 11, 61 zugewandten Oberflächen des Formteils 4 aufgebracht. Die Dicke der Beschichtung 5 beträgt vorzugsweise zwischen 10 und 20 Prozent der Höhe des Formteils. Beispielsweise ist das Formteil 4 zwischen 100 und 300 Mikrometer, insbesondere ca. 200 Mikrometer hoch und die Beschichtung zwischen 20 und 50 Mikrometer, insbesondere ca. 30 Mikrometer dick.

Die Materialien des Formteils 4 und der Beschichtung 5 sind vorzugsweise unterschiedlich. Hierbei weist die Beschichtung 5 gegenüber dem Formteil 4 einen geringeren Schmelzpunkt auf. Dieser ist um mindestens 5-10°C geringer als derjenige des Formteils 4 und entspricht der beim Lötprozess erzielten Löttemperatur, sodass die Beschichtung 5 vorzugsweise vollständig aufschmilzt. Die Schmelztemperatur des Formteils 4 liegt oberhalb der Löttemperatur, sodass das Formteil 4 während des Lotprozesses nicht aufgeschmolzen wird. In einer Ausgestaltung, insbesondere falls das Formteil 4 aus einem Lot besteht, kann die Schmelztemperatur des Formteils 4 auch niedriger liegen, sodass das Formteil 4 zumindest angeschmolzen wird. Beispielsweise handelt es sich bei dem Material des Formteils 4 im Wesentlichen um PbSn5. Die Beschichtung 5 des Formteils 4 ist beispielsweise aus SnAgCu ausgeführt.

An Stelle der Beschichtung 5 kann das zweite Material auch als Formteil ausgebildet sein. Wesentlich an der Ausgestaltung mit zwei verschiedenen Materialien ist lediglich, dass neben dem Formteil 4 ein zweites Material, insbesondere ein Lot, vorliegt, welches bei einer niedrigeren Temperatur schmilzt und für eine feste Verbindung zwischen Bauteil 1 und Formteil 4, sowie Formteil 4 und Träger 6 sorgt. Das Formteil 4, die Beschichtung 5 des Formteils 4 und/oder die zweite Kontaktfläche 61 können vor dem Lötprozess mit Flussmittel versehen werden.

Eine Ausgestaltung ohne Beschichtung 5 ist ebenfalls möglich. Das Material des Formteils 4 und die Löttemperatur sind in diesem Fall derart zu wählen bzw. aufeinander abzustimmen, dass das Formteil 4 schmilzt oder zumindest anschmilzt und somit selbst für die Verbindung zwischen der ersten Kontaktfläche 11 des Bauteils 1 und der zweiten Kontaktfläche 61 des Trägers 6 sorgt.

Das Formteil 4 kann auch auf die zweite Kontaktfläche 61 des Trägers 6 aufgesetzt oder an dieser befestigt sein. Das Bauteil 1 mit dem angeformten Abstandshalter 2 wird dann derart auf den Träger 6 aufgesetzt, dass der Abstandshalter 2 in das Formteil 4 eingreift. Eine derartige Ausgestaltung bringt den Vorteil mit sich, dass das Bauteil 1 zentriert ist und eine optimale Ausrichtung auf dem Träger 6 besitzt. Ist das Formteil 4 bereits fest mit dem Träger 6 verbunden, wird eine zusätzliche Stabilität erzielt, da das Bauteil 1 und das Lot 4 beim Transport zum Lötofen relativ zueinander nicht verrutschen können.

In Fig. 2b sind das Bauteil 1 mit Formteil 4 nach Fig. 2a und der Träger 6 nach der Lötung dargestellt. Die Abmessung des beschichteten Formteils 4, 5 ist derart gewählt, dass die Höhe des Formteils 4 mit Beschichtung 5 zumindest geringfügig höher ist als die Höhe des Abstandshalters 2. Hierdurch wird bei der Lötung gewährleistet, dass sich auch unter dem Abstandshalter 2 Lot befindet. Beim Aufschmelzen der Beschichtung 5 des Formteils 4 fließt ein Teil der Beschichtung 5 unter den Abstandshalter 2, sodass eine vorzugsweise durchgängige Lotschicht ausgebildet ist, welche die zweite Kontaktfläche 61 bedeckt. Hierdurch ist ein besonders stabiler Kontakt zwischen Bauteil 1 und Träger 6 hergestellt. Formteil 4 und Beschichtung 5 bilden ein elastisches oder duktiles Element zwischen Träger 6 und Bauteil 1 und bewirken eine verbesserte Stabilität der Verbindung zwischen Träger 6 und Bauteil 1.

Es bestehen also verschiedene Möglichkeiten zur Verbindung des Bauteils 1 mit dem Träger 6 über einen Abstandshalter 2. Der Abstandshalter 2 dient in jedem Fall als elastisches Element zwischen Bauteil 1 und Träger 6 und führt so zu einer stabilen Verbindung. Der Abstandshalter 2 ist Teil des Bauteils 1. Zur weiteren Verbesserung der Stabilität kann weiterhin ein auf den Abstandshalter 2 aufgesetztes bzw. den Abstandshalter 2 umgebendes Formteil 4, insbesondere ein Lotformteil, vorhanden sein.

### Bezugszeichenliste

- 1: Bauteil
- 11: Erste Kontaktfläche
- 2: Abstandshalter
- 3: Lot
- 4: Formteil
- 5: Beschichtung
- 6: Träger
- 61: Zweite Kontaktfläche

## Patentansprüche

1. Verfahren zur Fertigung von Drucksensoren, wobei:
eine auf einer Leiterplatte montierte Sensorelektronik mittels mehrerer metallischer oder metallisierter bolzenförmiger Verbindungselemente (1) über Lötungen mit einem keramischen drucksensitiven Sensorelement (6) verbunden wird,
zum Verbinden der bolzenförmigen Verbindungselemente (1) mit dem keramischen Sensorelement (6) eine Lötung zwischen jeweils einer ersten Kontaktfläche (11) eines Verbindungselements (1) und einer zweiten Kontaktfläche (61) des Sensorelements (6) erfolgt,
über die metallischen oder metallisierten bolzenförmigen Verbindungselemente (1) und die Lötungen gleichzeitig auch die elektrische Kontaktierung des Sensorelements (6) erfolgt,
**dadurch gekennzeichnet, dass**
jeweils mindestens ein Abstandshalter (2) an der ersten Kontaktfläche (11) der Verbindungselemente (1) einstückig angeformt ist, um eine Beabstandung der ersten Kontaktfläche (11) des Verbindungselements (1) und der zweiten Kontaktfläche (61) des Sensorelements (6) zu bewirken,
die Abstandshalter (2) bolzenförmig ausgestaltet sind,
die Abstandshalter (2) eine Höhe zwischen 100 Mikrometer und 300 Mikrometer aufweisen, und
der Durchmesser der Abstandshalters (2) zwischen 10 und 40 Prozent, des Durchmessers der ersten Kontaktfläche (11) des Verbindungselements (1) beträgt.

2. Verfahren nach dem vorangehenden Anspruch, wobei
ein Formteil (4) auf den bolzenförmigen Abstandshalter (2) aufgesetzt wird, wobei die Höhe des Formteils (4) zumindest gleich der Höhe des Abstandshalters (2) ist, und wobei das Material des Formteils (4) derart gewählt wird, dass das Formteil (4) bei der Lötung zumindest im Wesentlichen konturstabil bleibt.

3. Verfahren nach Anspruch 2, wobei:
ein Lot (5) auf das Formteil (4) aufgebracht wird, welches bei der Lötung aufgeschmolzen wird.

4. Verfahren nach einem der vorangehenden Ansprüche, wobei die Lötung mit einem Aktivlot ausgeführt wird.

5. Verfahren nach einem der vorangehenden Ansprüche, wobei
das Verbindungselement (1) und der Abstandshalter (2) aus einem Metall oder einer Metalllegierung gefertigt sind.

6. Verfahren nach einem der vorangehenden Ansprüche, wobei
der Durchmesser des Abstandshalters (2) zwischen 15 und 20 Prozent, des Durchmessers der ersten Kontaktfläche (11) des Verbindungselements (1) beträgt.

## Claims

1. Procedure for the production of pressure sensors, wherein:
a sensor electronics unit mounted on a printed circuit board is connected to a ceramic pressure-sensitive sensor element (6), by means of solder joints, via several metal or metalized bolt-shaped connection elements (1),
a solder joint is implemented, in each case, between a first contact surface (11) of a connection element (1) and a second contact surface (61) of the sensor element (6) to connect the bolt-shaped connection elements (1) to the ceramic sensor element (6),
the electrical contact of the sensor element (6) is implemented simultaneously via the metal or metalized bolt-shaped connection elements and the solder joints,
**characterized in that**
at least one spacer (2) is formed, as a one-piece unit, on the first contact surface (11) of each of the connection elements (1) to create space between the first contact surface (11) of the connection element (1) and the second contact surface (61) of the sensor element (6),
the spacers (2) are designed in the form of a bolt,
the spacers (2) have a height between 100 micrometers and 300 micrometers, and
the diameter of the spacer (2) is between 10 and 40 percent of the diameter of the first contact surface (11) of the connection element (1).

2. Procedure as claimed in the previous claim, wherein
a molded part (4) is fitted on the bolt-shaped spacer (2), wherein the height of the molded part (4) is at least equal to the height of the spacer (2), and wherein the material of the molded part (4) is selected in such a way that the molded part (4) remains at least essentially stable, with regard to its contour, during the soldering process.

3. Procedure as claimed in Claim 2, wherein:
a solder (5) is applied to the molded part (4), which is melted during the soldering.

4. Procedure as claimed in one of the previous claims, wherein the solder joint is performed with an active solder.

5. Procedure as claimed in one of the previous claims, wherein the connection element (1) and the spacer (2) are made from a metal or metal alloy.

6. Procedure as claimed in one of the previous claims, wherein the diameter of the spacer (2) is between 15 and 20 percent of the diameter of the first contact surface (11) of the connection element (1).

## Revendications

1. Procédé destiné à la fabrication de capteurs de pression, pour lequel :
une électronique de capteur montée sur une carte de circuit imprimé est reliée à un élément capteur (6) céramique, sensible à la pression, par brasage de plusieurs éléments de liaison (1) métalliques ou métallisés, en forme de goujon,
un brasage étant effectué entre respectivement une première surface de contact (11) d'un élément de liaison (1) et une deuxième surface de contact (61) de l'élément capteur (6) pour relier les éléments de liaison (1) en forme de goujon à l'élément capteur (6) céramique,
le contact électrique de l'élément capteur étant simultanément réalisé par le biais des éléments de liaison métalliques ou métallisés, en forme de goujon, ainsi que par le biais des brasages,
**caractérisé en ce que**
sur la première surface de contact (11) des éléments de liaison (1) est formée à chaque fois au moins un écarteur (2) pour réaliser un écartement entre la première surface de contact (11) de l'élément de liaison (1) et la deuxième surface de contact (61) de l'élément capteur (6),
les écarteurs (2) étant conçus en forme de goujon,
les écarteurs (2) présentant une hauteur comprise entre 100 micromètres et 300 micromètres, et
le diamètre de l'écarteur (2) étant compris entre 10 et 40 pour-cent du diamètre de la première surface de contact (11) de l'élément de liaison (1).

2. Procédé selon la revendication précédente, pour lequel
une pièce moulée (4) est placée sur l'écarteur (2) en forme de goujon, la hauteur de la pièce moulée (4) étant au moins égale à la hauteur de l'écarteur (2), et le matériau de la pièce moulée (4) étant choisi de telle sorte que la pièce moulée (4) conserve pour l'essentiel des contours stables lors du brasage.

3. Procédé selon la revendication 2, pour lequel :
une brasure (5) est appliquée sur la pièce moulée (4), laquelle est fondue lors du brasage.

4. Procédé selon l'une des revendications précédentes, pour lequel le brasage est exécuté avec une brasure active.

5. Procédé selon l'une des revendications précédentes, pour lequel l'élément de liaison (1) et l'écarteur (2) sont fabriqués en un métal ou un alliage métallique.

6. Procédé selon l'une des revendications précédentes, pour lequel le diamètre de l'écarteur (2) est compris entre 15 et 20 pour-cent du diamètre de la première surface de contact (11) de l'élément de liaison (1).
